(19) Europäisches Patentamt
European Patent Office
Office européen des brevets

(11) **EP 4 723 455 A1**

(12) **EUROPEAN PATENT APPLICATION**

(43) Date of publication:
08.04.2026 Bulletin 2026/15

(21) Application number: 24205016.9

(22) Date of filing: 07.10.2024

(51) International Patent Classification (IPC):
*H02M 1/00* *(2006.01)* *H02M 1/44* *(2007.01)*
*H02M 7/483* *(2007.01)*

(52) Cooperative Patent Classification (CPC):
H02M 7/4835; H02M 1/0043; H02M 1/44

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: GE Vernova Technology GmbH
5400 Baden (CH)

(72) Inventors:
• WAN, Jiqiang
Stafford, ST16 1WS (GB)

• NOLAN, Andrew
Stafford, ST16 1WS (GB)
• STOTT, Timothy
Stafford, ST16 1WS (GB)
• DAVIDSON, Colin
Stafford, ST16 1WS (GB)
• VODDEN, John
Stafford, STS16 1WS (GB)

(74) Representative: Openshaw & Co.
8 Castle Street
Farnham, Surrey GU9 7HR (GB)

(54) **SYSTEM AND METHOD FOR CONTROLLING A POWER ELECTRONICS DEVICE IN A POWER TRANSMISSION NETWORK**

(57) There is provided a method (300), and a controller (160), for controlling a plurality of submodules (212) in a valve (224) of a power electronics device (290). The method comprises determining, by the controller (160), a time period in which selected submodules of the plurality of submodules (212) are to be switched in order to control an output voltage of the valve (224); determining, by the controller (160), for each of the selected submodules, a respective switching time, within the time period, based on a voltage demand for the time period and a voltage of each of the selected submodules, wherein at least one of the respective switching times is different to another of the respective switching times; generating, by the controller (160), a respective switching command (270) for each of the selected submodules; and providing, by the controller, the respective switching commands (270) to the valve (224), whereby to control the selected submodules to switch at the respective switching times within the time period.

Figure 2C

EP 4 723 455 A1

**Description**

FIELD OF THE INVENTION

The present invention relates to a system and a method for controlling a power electronics device, and more particularly a system and a method for controlling a switching of sub-modules in a valve of a power electronics device.

BACKGROUND

In high voltage direct current (HVDC) power transmission networks alternating current (AC) power is typically converted to direct current (DC) power for transmission via a power transmission medium, for example overhead lines, under-sea cables, and/or underground cables. The conversion between DC power and AC power is utilised where it is necessary to interconnect DC and AC power, for example between an AC grid and a HVDC transmission line. In power transmission networks, power conversion means, also known as converter stations (i.e., power converters in converter stations, power inverters etc.) are required at each interface or interconnection between AC and DC power to implement the required conversion from AC to DC or from DC to AC.

A type of power electronics device used in some HVDC transmission systems is a power converter, for example a Voltage Source Converter (VSC). Another type of power electronics device used in AC transmission systems is a static synchronous compensator (STATCOM). Both the VSC and the STATCOM may comprise valves which comprise a plurality of submodules. In each valve the submodules are switched, based on a switching signal, to provide power at an output of the VSC or STATCOM.

An external controller is conventionally used to provide the switching signal. The external controller issues voltage demands at specific time periods to a Valve Base Electronic Unit (VBE). A switching algorithm in the VBE selects and switches submodules in and out of the valve, whereby to output a voltage from the valve and thus achieve the voltage demand for the VSC or STATCOM for the specific time period.

SUMMARY OF THE INVENTION

The inventors have realised that simultaneously switching a plurality of submodules in a valve tends to cause resonance, for example resonance in the valve, resonance in a power electronics device that comprises one or more valves, for example a power converter or STATCOM, or resonance in components connected to the power electronics device. The inventors have further realised that the resonance is increased as the number of simultaneously switching submodules is increased. In light of these considerations, it is desired to develop a controller for a valve that can reduce resonance, and thus achieve a smoother and more accurate voltage output.

According to a first aspect, there is provided a method for controlling a plurality of submodules in a valve of a power electronics device, the method comprising: determining, by a controller, a time period in which selected submodules of the plurality of submodules are to be switched in order to control an output voltage of the valve; determining, by the controller, for each of the selected submodules, a respective switching time, within the time period, based on a voltage demand for the time period and a voltage of each of the selected submodules, wherein at least one of the respective switching times is different to another of the respective switching times; generating, by the controller, a respective switching command for each of the selected submodules; and providing, by the controller, the respective switching commands to the valve, whereby to control the selected submodules to switch at the respective switching times within the time period.

Each respective switching command may include the respective switching time.

The respective switching commands may be provided to the valve substantially at the start of the time period.

The respective switching commands may be provided to the valve substantially before the time period.

Each respective switching command may be provided to the valve at the respective switching time.

The method may further comprise specifying, by the controller, the selected submodules of the plurality of submodules to be switched during the time period.

The method may further comprise receiving, by the controller, a command which specifies the selected submodules of the plurality of submodules to be switched during the time period.

The method may further comprise determining, by the controller, a voltage step for the time period by calculating a change in a voltage demand for the valve during the time period; receiving, by the controller, the voltage of each of the selected submodules from the valve; and using, by the controller, the voltage for each of the selected submodules and the voltage step to determine the respective switching times.

Using the voltage for each of the selected submodules and the voltage step to determine the respective switching times may comprise: numbering, by the controller, the selected submodules from 1 to N, wherein N is a total number of the selected submodules; calculating, by the controller, a cumulative voltage for each of the selected submodules between 1 and N, by implementing the equation:

$$V_C(n) = \sum_{i=1}^{n} V_{SM}(i)$$

wherein n is a specific submodule of the selected submodules between 1 and N, $V_C(n)$ is the cumulative voltage for the specific submodule $n$, and $V_{SM}(i)$ is a respective voltage for a respective selected submodule i; and calculating, by the controller, the switching times for the selected submodules between 1 and N, by implementing the equation:

$$RS(n) = T \times \frac{V_C(n)}{V_S}$$

wherein T is the time period, $V_S$ is the voltage step for the time period, and RS($n$) is the switching time of the specific submodule n.

The numbering from 1 to N can be random or in sorted order from lowest to highest submodule voltage or from highest to lowest submodule voltage.

The method may further comprise comparing, by the controller, the total number of selected submodules N to a selected submodule limit.

If the total number of selected submodules is less than or equal to the selected submodule limit, then the method may further comprise determining, by the controller, the respective switching times for the selected submodules.

If the total number of selected submodules is greater than the selected submodule limit, then the method may further comprise determining, by the controller, the respective switching times for a number of selected submodules equal to the selected submodule limit, and determining a static switching time for each remaining selected submodule.

The static switching time may be substantially equal to or less than the time period divided by two.

The method may further comprise determining, by the controller, an adjustment term by implementing the equation:

$$A = \sum_{i=1}^{N} \frac{RS(i) \times V_{SM}(i)}{V_S}$$

wherein $A$ is the adjustment term, and RS($i$) is the respective switching time for a respective selected submodule i; and determining, by the controller, respective adjusted switching times for the respective submodules, by subtracting the adjustment term from the respective switching times for the selected submodules.

Determining the voltage step for the time period may comprise determining, by the controller, a valve voltage droop caused by a valve current; and adding, by the controller, the valve voltage droop to the change in the voltage demand to determine the voltage step.

The valve voltage droop may be determined by calculating a valve voltage change rate caused by a valve current, and multiplying the valve voltage change rate by a time duration or the time period.

The valve voltage droop may be determined by implementing the equation to calculate the change in valve voltage:

$$DV = \sum_{i=1}^{M} \frac{dV_{SM}(i)}{dt}$$

where DV is a change in valve voltage over the time period or a time duration, and M is the total number of in-circuit submodules, $\frac{dV_{SM}(i)}{dt}$ is the rate of change in a submodule i voltage.

The valve voltage droop is equal to the negative of DV (i.e., -DV).

Alternately, DV may be calculated from a valve current and valve capacitance, by implementing the equation:

$$DV = \frac{Idt}{C}$$

where I is the valve current and C is the valve capacitance.

The valve voltage can then be determined by implementing the equation:

$$Vdroop = \sum_{i=1}^{M} V_{SM}{}'(i) - V_{SM}(i)$$

where Vdroop is the valve voltage droop, $V_{SM}{}'(i)$ is a previous submodule (capacitor) voltage, and $V_{SM}(i)$ is the present submodule (capacitor) voltage.

Other methods may also be used to calculate a change in valve voltage over the time period or a time duration, to determine the valve voltage droop from the submodule capacitor voltage or valve current.

Determining the voltage step for the time period may comprise comparing, by the controller, the change in the voltage demand to an upper limit and a lower limit; and setting, by the controller, in response to the change in the voltage demand exceeding the upper limit, the change in the voltage demand to the upper limit.

Determining the voltage step for the time period may comprise comparing, by the controller, the change in the voltage demand to an upper limit and a lower limit; and setting, by the controller, in response to the change in the voltage demand being lower than the lower limit, the change in the voltage demand to the lower limit.

Setting the change in the voltage demand in this manner tends to limit the number of selected submodules which are given a different respective switching time.

The voltage of each of the selected submodules may be a voltage of one or more energy storage devices of the selected submodule.

The method may further comprise adding, by the controller, a constant term to each of the respective switching times in order to shift the respective switching times relative to the time period.

The constant term may be substantially less than or equal to the time period divided by two.

The method may further comprise adding, by the controller, a random value to each of the respective switching times.

The random value may be substantially less than the time period.

The random value may be less than or equal to 15%; or 10%; or 5%; or 4%; or 3%; or 2%; or 1 %, of the time period.

According to a second aspect, there is provided a controller for controlling a plurality of submodules in a valve of a power electronics device, the controller configured to: determine a time period in which selected submodules of the plurality of submodules are to be switched in order to control an output voltage of the valve; determine for each of the selected submodules, a respective switching time, within the time period, based on a voltage step for the time period and a voltage of each of the selected submodules, wherein at least one of the respective switching times is different to another of the respective switching times; generate respective switching commands for each of the selected submodules; and provide the respective switching commands to the valve, whereby to control the selected submodules to switch at the respective switching times within the time period.

Generally, the controller disclosed herein tends to be configured to execute the methods described herein.

The controller may be further configured to determine a voltage step for the time period by calculating a change in a voltage demand for the valve during the time period; receive the voltage of each of the selected and/or in-circuit submodules from the power converter; and use the voltage for each of the selected and/or in-circuit submodules and the voltage step to determine the respective switching times.

According to a third aspect, there is provided a power electronics device comprising one or more valves, wherein each valve comprises a plurality of submodules, and wherein each valve is configured to output a voltage for an AC network; and the controller of the second aspect configured to control each valve.

The power electronics device may be a power converter.

The power electronics device may be for a High or Medium Voltage Direct Current system.

The power electronics device may be a Voltage Source Converter.

The power electronics device may comprise a plurality of valves. Each valve may comprise a plurality of submodules.

The power electronics device may be a Modular Multilevel Converter.

The power electronics device may be a STATCOM.

According to a fourth aspect, there is provided a computer program comprising instructions which when executed by a processor of a controller, cause the controller to perform the method of the first aspect.

According to a fifth aspect, there is provided a non-transitory computer-readable storage medium comprising the computer program of the fourth aspect.

It will be appreciated that particular features of different aspects of the invention share the technical effects and benefits of corresponding features of other aspects of the invention. More specifically, the technical effects and benefits of the controller, the power electronics device, the computer program, and the non-transitory computer-readable medium, are shared by the method of the invention.

It will also be appreciated that the use of the terms "first" and "second", and the like, are merely intended to help distinguish between similar features and are not intended to indicate a relative importance of one feature over another, unless otherwise specified.

Within the scope of this application, it is expressly intended that the various aspects, embodiments, examples and alternatives set out in the preceding paragraphs, and the claims and/or the following description and drawings, and in particular the individual features thereof, may be taken independently or in any combination. That is, all embodiments and all features of any embodiment can be combined in any way and/or combination, unless such features are incompatible.

BRIEF DESCRIPTION OF THE DRAWINGS

Figure 1A is a schematic illustration of a power transmission network;

Figure 1B is a schematic illustration of a system comprising a controller, a STATCOM, and an AC network;

Figure 2A is a schematic illustration of a power converter and a controller;

Figure 2B is a schematic illustration of a STATCOM and a controller;

Figure 2C is a schematic illustration of a controller connected to a valve;

Figure 3 is a process flow chart showing steps of a method for controlling submodules in a valve;

Figure 4 is a process flow chart showing steps of a process performed during the method of Figure 3;

Figure 5A is a graph showing a change in a valve voltage plotted against time, during a time period wherein two submodules are switched, for a valve controlled using a conventional method;

Figure 5B is a graph showing a change in a valve voltage plotted against time, during a time period wherein two submodules are switched, for a valve controlled using the methods disclosed herein;

Figure 6A is a graph showing a change in a valve voltage plotted against time, during a time period wherein seven submodules are switched, for a valve controlled using a conventional method;

Figure 6B is a graph showing a change in a valve voltage plotted against time, during a time period wherein seven submodules are switched, for a valve controlled using the methods disclosed herein;

Figure 7A is a graph showing a change in a valve voltage plotted against time, during a time period wherein one submodule is switched, for a valve controlled using a conventional method;

Figure 7B is a graph showing a change in a valve voltage plotted against time, during a time period wherein one submodule is switched, for a valve controlled using the methods disclosed herein;

Figure 8 is a graph showing switching times of submodules of different voltages plotted against time, controlled using the methods disclosed herein; and

Figure 9 is a graph showing the output voltage of a valve plotted against time, of a valve controlled using a conventional method (bold plot) and a valve controlled using the methods disclosed herein (non-bold plot).

DETAILED DESCRIPTION

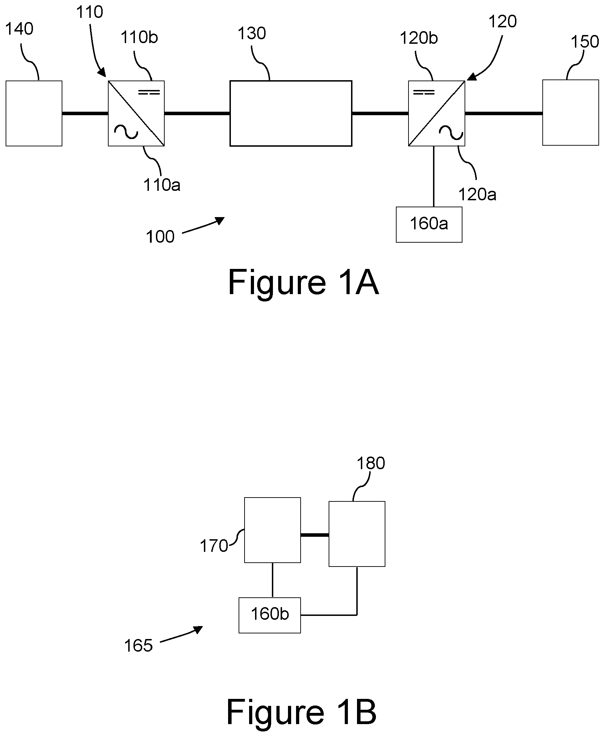

Figure 1A illustrates a power transmission network 100. The illustration is not intended to be limited to representing a particular power transmission scheme, such as a monopole or a bipole High Voltage Direct Current (HVDC) transmission network. In this manner, the power transmission network 100 may represent, generically, a monopole or bipole scheme, or may represent a multiterminal power transmission scheme, for instance. Hence whilst specific features in the illustration are shown connected to each other with a specific number of connections, it will be understood that this is not intended to be limiting either. Related, is that relative dimensions or distances between components perceived in the illustration are also not intended to be limiting.

The power transmission network 100 includes a first power converter 110 (also known as a converter, inverter, etc.), a second power converter 120, a transmission medium 130, a first AC network 140, a second AC network 150, and a controller 160a.

The controller 160a is arranged to be communicatively coupled to the second power converter 120 in order to control the second power converter 120 by executing the methods described herein. Such a controller may be referred to as a controller means or control means, and is discussed in more detail later below.

The first power converter 110 and the second power converter 120 are each an example of a power electronics device.

The power converters 110, 120, are configured to convert AC power to DC power, acting essentially as rectifiers; or DC power to AC power, acting essentially as inverters. The power converters 110, 120 may each comprise a single converter in the case of a monopole system, or two converters in the case of a bipole system. The power converters 110, 120 may represent a plurality of converter stations arranged as a multi-terminal power transmission system. Generically, the first power converter 110 comprises a first AC side 110a and a first DC side 11 0b. Generically, the second power converter 120 comprises a second AC side 120a and a second DC side 120b.

The first power converter 110 is connected to a first AC network 140. The first AC network 140 is connected to the first AC side 110a of the first power converter 110. The second power converter 120 is connected to a second AC network 150. The second AC network 150 is connected to the second AC side 120a of the second power converter 120.

The first AC network 140 and/or second AC network 150 may be electrical power transmission systems comprising power generation apparatus, transmission apparatus, distribution apparatus, and electrical loads. The first AC network 140 and/or second AC network 150 may comprise a renewable power generation network such as a wind-power generation network, solar-power generation network, bio-power generation network. The first AC network 140 or second AC network 150 may be a consumer network, or a network containing a mix of consumers and generators. By way of non-limiting example, the first AC network 140 may be a power generation network, with second AC network 150 being a network containing a mix of consumers and generators, for instance. In particular examples, the power converters 110, 120 may be geographically remote. For instance, the first power converter 110 may reside on an off-shore platform connected to a wind farm, and the second power converter 120 may reside on-shore.

The power transmission medium 130 connects the first power converter 110 and the second power converter 120. The power transmission medium 130 is connected between the first DC side 110b of the first power converter 110 and the second DC side 120b of the second power converter 120. The power transmission medium 130 may comprise electrical cables and other electrical components for connecting the first and second power converters 110, 120. For instance, the power transmission medium 130 may comprise a conductor providing a first electrical pole and/or a conductor providing a second electrical pole. A neutral arrangement may also be provided interconnecting the first and second power converters 110, 120. The power transmission medium 130 provides the medium through which DC power is transferred between the power converters 110, 120.

The operation of the power transmission network 100 can be generically described as follows. The first AC network 140 generates AC power that is provided to the first power converter 110 at the first AC side 110a. The first power converter 110 converts the received AC power to DC power for transmission to the transmission medium 130. The DC power is transmitted from the first DC side 110b of the first power converter 110 to the transmission medium 130. The second DC side 120b of the second power converter 120 receives DC power from the transmission medium 130. The second power converter 120 converts the received DC power to AC power. The AC power is then provided from the second AC side 120a of the second power converter 120 to the second AC network 150 for consumption, for instance.

As the second power converter 120 receives power from the transmission medium 130, the first power converter 110 transfers power from the AC network 140 to the transmission medium 130, such that the nominal voltage of the transmission medium 130 is maintained.

Additionally, in some circumstances, the first power converter 110 can also receive power from the transmission medium 130. The first power converter 110 can thus be configured to transfer real or reactive power in either direction, into or out of the first AC network 140. The second power converter 120 can also be configured to transfer real or reactive power in either direction, into or out of the second AC network 150.

The power transmission network 100 may be operated using methods such as synchronous grid forming (SGFM) wherein either or both of the power converters 110, 120 behave as three-phase, positive-phase sequence AC voltage sources behind an impedance, that operate at a frequency synchronous with other SGFM sources connected to the power transmission network 100.

The power transmission network 100 may further comprise controllers for controlling operations of components of the power transmission network 100.

Figure 1B shows an example of a system 165 comprising a controller 160b connected to a STATCOM 170 and a third AC network 180. The STATCOM 170 is also connected to the third AC network 180.

The STATCOM 170 is an example of a power electronics device.

The controller 160b is arranged to be communicatively coupled to the STATCOM 170 in order to control the STATCOM 170 by executing the methods described herein. Such a controller may be referred to as a controller means or control means, and is described in more detail later below.

The STATCOM 170 is configured such that real and/or reactive power can be transferred between the STATCOM 170 and the third AC network 180.

The STATCOM 170 generally tends to provide a source or sink of reactive power for the third AC network 180 with a fast-response time. Thus, in the event of a sudden load change in the third AC network 180, reactive power tends to be transferred into or out of the STATCOM 170, in order to maintain stability of the third AC network 180.

It will be appreciated that various other electrical components may be located at any particular location or with any particular feature/component in the example power transmission network 100 or system 165. These may include switches, transformers, resistors, reactors, surge arrestors, harmonic filters and other components well known in the art.

It will be appreciated that converters or power conversion means may comprise a number of different technologies such as voltage sourced converters (for instance using insulated gate bipolar transistor (IGBT) valves). Such converters may generally be considered to use 'power electronics'. Power electronic converters may comprise multi-level voltage sourced converters, for instance.

It will be appreciated that cables used as power transmission mediums may comprise the following non-limiting examples of crosslinked polyethylene (XLPE) and/or mass impregnated (MI) insulation cables. Such cables may comprise a conductor (such as copper or Aluminium) surrounded by a layer of insulation. Dimensions of cables and their associated layers may be varied according to the specific application (and in particular, operational voltage requirements). Cables may further comprise strengthening or 'armouring' in applications such as subsea installation. Cables may further comprise sheaths/screens that are earthed at one or more locations.

Moreover, it will be understood that the power transmission network 100 may be used with three-phase power systems. In a three-phase power system, three conductors supply respective first, second and third phases of AC power to a consumer. Each of the first, second and third phases will typically have equal magnitude voltages or currents, which are displaced in phase from each other by 120°.

In a three-phase power system, phase currents and voltages can be represented by three single phase components: a positive sequence component; a negative sequence component; and a zero-sequence component. It is the positive sequence component that rotates in phase in accordance with the power system. Hence, in a preferred scenario, only positive sequence voltage/current will exist. It will be understood that an unbalance in voltage or current between the first, second and third-phases, of a three-phase system, in magnitude or phase angle, can give rise to undesirable negative or zero-sequence components. Such an unbalance can be caused by fault conditions, for instance in the first and second AC networks 140, 150.

The controllers 160a, 160b are controllers or control means configured to control a valve. A reference to a controller 160 herein is a reference to either one of the controllers 160a, 160b. In other words, both of the controllers 160a, 160b are configured in a substantially similar way, and therefore, unless stated otherwise, the following description of the controller 160 is applicable to either one or both of the controllers 160a, 160b.

The controller 160 is generally configured to control a valve of a power electronics device. The power electronics device may be a power converter, such as the first or second power converter 110, 120. The power electronics device may be the STATCOM 170.

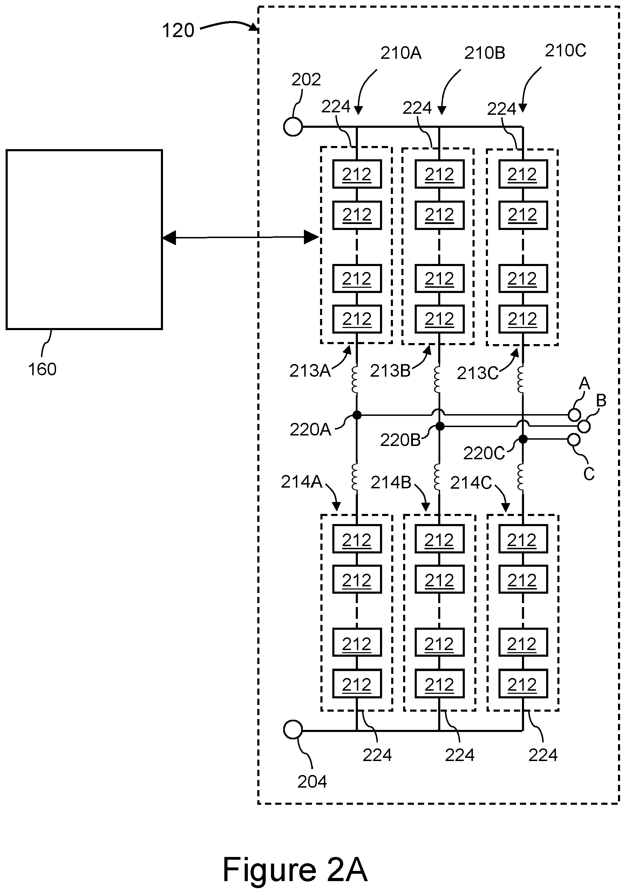

Figure 2A is a schematic illustration (not to scale) showing a first example of the controller 160 connected to a valve of a power electronics device. In the first example, the power electronics device is the second power converter 120.

The power converter 120 includes first and second DC terminals 202, 204. The first and second DC terminals 202, 204 are connected to a DC source for example, the power transmission medium 130.

A first converter phase 210A, a second converter phase 210B, and a third converter phase 210C (alternatively referred to as phase units, converter limbs etc.), extends between the first and second DC terminals 202, 204. The first, second and third converter phases 210A, 210B, 210C each correspond to a given phase A, B, C of a three-phase AC network.

Each converter phase 210A, 210B, 210C includes a first phase arm 213A, 213B, 213C (alternatively referred to as a limb portion), and second phase arm 214A, 214B, 214C. Each first phase arm 213A, 213B, 213C may be connected to a positive pole of the power transmission medium 130. Each second phase arm 214A, 214B, 214C may be connected to a negative pole of the power transmission medium 130. The first and second phase arms 213A, 213B, 213C, 214A, 214B, 214C are separated by corresponding AC terminals 220A, 220B, 220C.

Each AC terminal 220A, 220B, 220C is connected to a respective phase A, B, C of the three-phase AC network. The three-phase AC network may be, for example, the second AC network 150 as shown in Figure 1.

Other embodiments of the invention may include fewer than or greater than three converter phases, depending on the configuration of an associated AC network with which the power converter 120 is intended to be connected.

Each phase arm 213A, 213B, 213C, 214A, 214B, 214C includes a valve 224 (alternatively referred to as a chain-link converter) which extends between the associated AC terminal 220A, 220B, 220C and a corresponding one of the first or the second DC terminal 202, 204.

Each valve 224 includes a plurality of series connected submodules 212 (alternatively referred to as chain-link modules).

Each submodule 212 includes a number of switching elements (not shown) which are connected to an energy storage device in the form of a capacitor, although other types of energy storage device, i.e., any device that is capable of storing and releasing energy to selectively provide a voltage, for example a fuel cell or battery, may also be used.

Each switching element typically includes a semiconductor device, typically in the form of an Insulated Gate Bipolar Transistor (IGBT).

It is, however, possible to use other types of self-commutated semiconductor devices, such as a gate turn-off thyristor (GTO), a field effect transistor (FET), a metal-oxide-semiconductor field-effect transistor (MOSFET), an injection-enhanced gate transistor (IEGT), an integrated gate commutated thyristor (IGCT), a bimode insulated gate transistor (BIGT) or any other self-commutated switching device. In addition, one or more of the semiconductor devices may instead include a wide-bandgap material such as, but not limited to, silicon carbide, boron nitride, gallium nitride and aluminium nitride.

The number of semiconductor devices in each switching element may vary depending on the required voltage and current ratings of that switching element.

Each of the switching elements may also include a passive current check element that is connected in anti-parallel with a corresponding semiconductor device. The or each passive current check element may include at least one passive current check device. The or each passive current check device may be any device that is capable of limiting current flow in only one direction, e.g. a diode. The number of passive current check devices in each passive current check element may vary depending on the required voltage and current ratings of that passive current check element.

A first exemplary submodule may include a first pair of switching elements that are connected in parallel with a capacitor in a known half-bridge arrangement to define a 2-quadrant unipolar module. Switching of the switching elements selectively directs current through the capacitor or causes current to bypass the capacitor, such that the first exemplary submodule can provide zero or positive voltage and can conduct current in two directions.

A second exemplary submodule may include first and second pairs of switching elements and a capacitor are connected in a known full bridge arrangement to define a 4-quadrant bipolar module. In a similar manner to the first exemplary chain-link module, switching of the switching elements again selectively directs current through the capacitor or causes current to bypass the capacitor such that the second exemplary submodule can provide zero, positive or negative voltage and can conduct current in two directions.

Each valve 224 may include solely first exemplary submodules, solely second exemplary submodules, or a combination of first and second exemplary submodules.

In any event, the provision of a plurality of submodules 212 means that it is possible to build up a combined voltage across each valve 224, via the insertion of the energy storage devices, i.e., the capacitors, of multiple submodules 212 (with each submodule 212 providing its own voltage), which may be higher than the voltage available from each individual submodule 212.

Accordingly, the submodules 212 work together to permit the valve 224 to provide a stepped variable voltage source. This permits the generation of a voltage waveform output from each valve 224. As such each valve 224 is capable of providing a wide range of complex waveforms.

The controller 160 is communicatively coupled to the power converter 120 to control an operation of the valves 224 to generate an AC voltage waveform at each AC terminal 220A, 220B, 220C, and thereby enable the power converter 120 to, in use, provide power transfer functionality between the AC and DC terminals.

For clarity, in Figure 2A only the valve 224 of the first phase arm 213A is shown as being communicatively coupled to the controller 160. However, it is to be understood that the methods disclosed herein are equally applicable to any one of the valves 224 of the power converter 120.

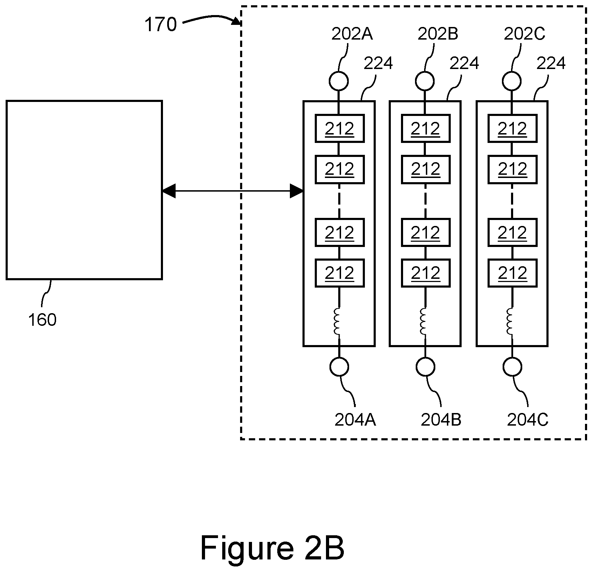

Figure 2B is a schematic illustration (not to scale) showing a second example of the controller 160 connected to a valve of a power electronics device. In the second example, the power electronics device is the STATCOM 170.

The STATCOM 170 includes a plurality of valves 224. In this example, the STATCOM 170 includes three valves 224. Each valve 224 extends between a respective first terminal 202A, 202B, 202C and a respective second terminal 204A, 204B, 204C.

Each first terminal 202A, 202B, 202C and second terminal 204A, 204B, 204C is connected to a phase of the third AC network 180, such that the valves 224 are arranged in either a star or delta configuration.

For example, in order to configure the valves 224 in a star configuration, each of the first terminals 202A, 202B, 202C may be connected to a different respective phase of the third AC network 180, whilst each of the second terminals 204A, 204B, 204C may be connected together.

Alternatively, in order to configure the valves 224 in a delta configuration, the first terminals 202A, 202B, 202C and second terminals 204A, 204B, 204C may be connected in pairs, each pair to a different respective phase of the third AC network 180.

Other embodiments of the invention may include fewer than or greater than three phases, depending on the configuration of an associated AC network with which the STATCOM 170 is intended to be connected. Thus, other configurations of the valves 224 are also possible.

Each valve 224 includes a plurality of series connected submodules 212 (alternatively referred to as chain-link modules). Each submodule 212 is the same as the submodules 212 described above in relation to Figure 2A.

Each valve 224 may include solely first exemplary submodules, solely second exemplary submodules, or a combination of first and second exemplary submodules.

In any event, the provision of a plurality of submodules 212 means that it is possible to build up a combined voltage across each valve 224, via the insertion of the energy storage devices, i.e., the capacitors, of multiple submodules 212 (with each submodule 212 providing its own voltage), which is higher than the voltage available from each individual submodule 212.

Accordingly, the submodules 212 work together to permit the valve 224 to provide a stepped variable voltage source. This permits the generation of a voltage waveform output from each valve 224. As such each valve 224 is capable of providing a wide range of complex waveforms.

The controller 160 is communicatively coupled to the STATCOM 170 to control an operation of the valves 224 to generate an AC voltage waveform between the first and second terminals 202A, 202B, 202C, 204A, 204B, 204C, and thereby enable the STATCOM 170 to, in use, provide power transfer functionality to or between each phase of the third AC network 180.

For clarity, in Figure 2B only one valve 224 is shown as being communicatively coupled to the controller 160. However, it is to be understood that the methods disclosed herein are equally applicable to any one of the valves 224 of the STATCOM 170.

It is to be understood that the methods disclosed herein can generally be used to control any valve of a power electronics device. Thus, the invention is equally applicable to the first example wherein the controller is connected to valve of the second power converter 120, as it is to the second example wherein the controller is connected to a valve of the STATCOM 170. Importantly, across all embodiments, the controller is configured to control a valve.

An embodiment of the invention is now disclosed wherein the controller 160 is configured to control a valve 224 according to the methods disclosed herein.

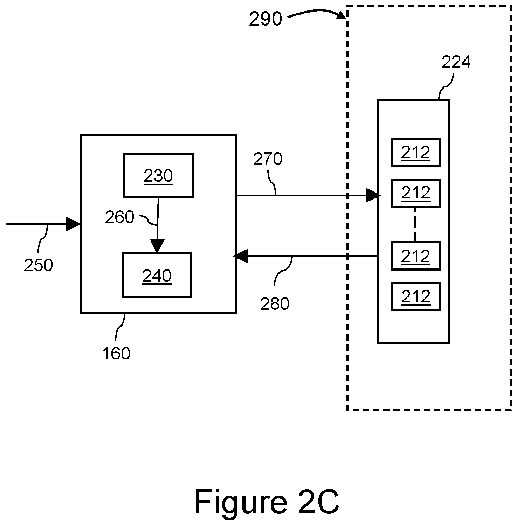

With reference to Figure 2C, the controller 160 comprises a Valve Base Electronic unit (VBE) 230 and a timing controller 240. The controller 160 is communicatively coupled to a valve 224 of a power electronics device 290.

The valve 224 may be the valve 224 from Figures 2A or 2B. The power electronics device 290 may be the second power converter 120, or the STATCOM 170.

The controller 160 is configured to receive a voltage demand 250. The voltage demand 250 is provided to the controller 160 by an external controller, for example by an external controller (not shown). The voltage demand 250 specifies a voltage to be output from the valve 224 for a respective time period, in order to achieve a desired output voltage from the valve 224 for the respective time period.

For example, for the valve 224 to output a sinusoidal voltage waveform, a time period of 100μs may be used. In this example, the voltage demand 250 will specify, for every 100μs (i.e., per time period), the voltage to be output from the valve 224 that is needed in order to achieve the desired sinusoidal voltage waveform.

The VBE 230 is configured to implement an algorithm that selects submodules 212 in the valve 224 to be switched (for example, switched in or switched out of the valve 224), in order to achieve the desired output voltage from the valve 224, as specified in the voltage demand 250, for the respective time period. The VBE 230 is configured to output a command 260 which specifies the selected submodules, from the plurality of submodules 212 within the valve 224 to be switched during the respective time period. In this manner, the VBE 230 is configured to determine the command 260 based on the voltage demand 250.

A conventional controller may provide the command 260 directly to the valve 224 at the start of a respective time period. A conventional valve may be configured to receive the command 260, and directly implement a switching of the selected submodules 212 according to the command 260. Thus, because a conventional controller tends to provide the command 260 to the valve at the start of the time period, the selected submodules conventionally tend to switch simultaneously at the start of the time period.

As discussed above, the inventors have realised that simultaneously switching a plurality of submodules in a valve tends to cause resonance, for example resonance in the valve 224, resonance in the power electronics device 290, or resonance in components connected to the power electronics device 290. The inventors have further realised that the resonance is increased as the number of simultaneously switching submodules is increased. Thus, if, for example, 7 or 8 submodules are simultaneously switched at the start of a time period, the amount of resonance tends to be considerably greater, compared to when only 1 submodule is switched at the start of a time period.

In particular, switching 7 or 8 submodules may cause high frequency resonance in the kHz or MHz range. Resonance in this range tends to increase RFI significantly.

Thus, the inventors have realised that the simultaneous switching of a plurality of submodules in a time period tends to cause resonance in the valve, for example, high frequency resonance at 10kHz at a 100μs time period.

In light of these considerations, it is desired to develop a controller for a valve 224 that can reduce resonance, and thus achieve a smoother and more accurate voltage output from the valve 224.

In this embodiment, instead of providing the command 260 directly to the valve 224, the command 260 is instead provided to the timing controller 240. The timing controller 240 is configured to receive the command 260, and to determine, for each of the selected submodules specified by the command 260, a respective switching time. At least one of the switching times determined for a selected submodule is different from another of the switching times determined for a different selected submodule.

The controller 160 is configured to provide commands to the valve 224 in accordance with the determined respective switching times, in the form of switching commands 270. Providing the switching commands 270 thus, in essence, comprises providing the switching information contained in the command 260 at staggered intervals, the intervals corresponding to the respective switching times, as discussed in more detail later below.

The timing controller 240 is also configured to receive data 280 from the valve 224 or the power electronics device 290. The data 280 comprises, for example, voltage and current information of components of the power electronics device 290, as will be discussed further below.

Thus, in this embodiment, the switching commands 270 cause the submodules 212 within the valve 224 to achieve a desired valve output voltage. The methods used by the controller 160 to determine and provide the switching commands 270 are discussed in more detail later below. As a result of providing the switching commands 270 to the valve 224, a number of simultaneously switching submodules tends to be decreased or reduced to zero, and thus an amount of resonance, that would have otherwise been caused by simultaneously switching submodules, also tends to be decreased.

In addition to the above-described features, the controller 160 may comprise a memory and at least one processor. The memory may comprise computer-readable instructions, which when executed by the at least one processor, cause the controller to perform the method/s described herein.

The controller 160 may also comprise a transceiver arrangement which may comprise a separate transmitter and receiver. The transceiver arrangement may be used to operatively communicate with other components or features of embodiments described herein either directly or via a further interface such as a network interface. The transceiver arrangement may for instance send and receive control signals using transmitter and receiver. The control signals may contain or define electrical control parameters such as reference currents or reference voltages. The controller 160 may be communicatively coupled to the power electronics device 290, or the valve 224, by optical means; and/or wired means; and/or wireless means.

The at least one processor is capable of executing computer-readable instructions and/or performing logical operations. The at least one processor may be a microcontroller, microprocessor, central processing unit (CPU), application-specific integrated circuit (ASIC), field programmable gate array (FPGA) or similar programmable or unprogrammable controller. The processor is communicatively coupled to the memory and may in certain embodiments be coupled to the transceiver.

The memory may be a computer readable storage medium. For instance, the memory may include a non-volatile computer storage medium. For example, the memory may include a hard disk drive, flash memory etc.

The controller 160 may further comprise a user input device and/or output device.

The controller 160 may additionally include a user input device interface and/or a user output device interface, which may allow for visual, audible, or haptic inputs/outputs. Examples include interfaces to electronic displays, touchscreens, keyboards, mice, speakers, and microphones.

As discussed above, the controller 160 is configured to provide the switching commands 270 to the valve 224. The switching commands 270 comprise control signals that when received and implemented by the valve 224, cause submodules 212 within the valve 224 to switch, and thereby achieve a desired valve output voltage. The switching commands 270 are provided respectively for specific selected submodules at a specific time, as will now be discussed in more detail.

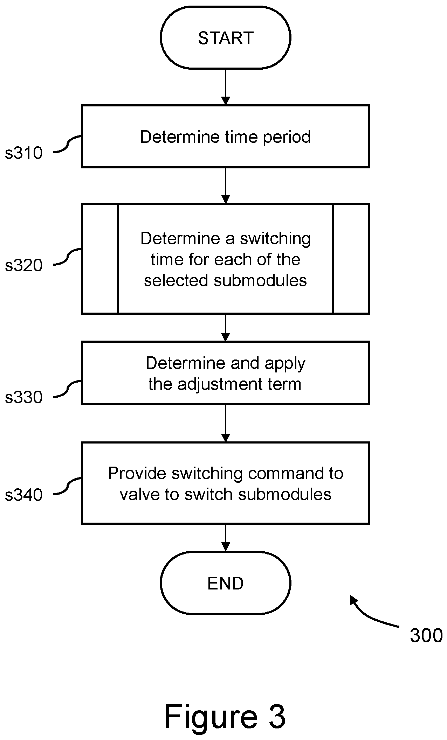

Figure 3 is a process flow chart showing certain steps of a method 300 for determining and then providing the switching commands 270 to the valve 224, for a respective time period, in order to control the submodules 212 within the valve 224. The method 300 is performed iteratively for each respective time period in order to, over multiple time periods, achieve a desired output voltage waveform from the valve 224. The timing controller 240 can be operated according to the method 300.

Prior to the start of the method 300, the VBE 230 has determined the command 260 based on a switching algorithm which specifies which submodules need to be connected into the valve 224. The command 260 thus specifies the selected submodules of the plurality of submodules 212 to be switched during the time period.

At step s310, the timing controller 240 determines a time period in which the selected submodules of the plurality of submodules 212 are to be switched in order to control an output voltage of the valve 224.

In some embodiments the time period may be fixed, and thus may be a value stored in or provided to the controller 160. In such embodiments, the controller 160 acquires the time period.

In other embodiments, for the time period may change over time. In such embodiments, the time period can be determined by the controller 160 receiving information of the AC frequency of a connected AC network, for example the third AC network 180 or the second AC network 150, and determining the time period based on the frequency of the connected AC network.

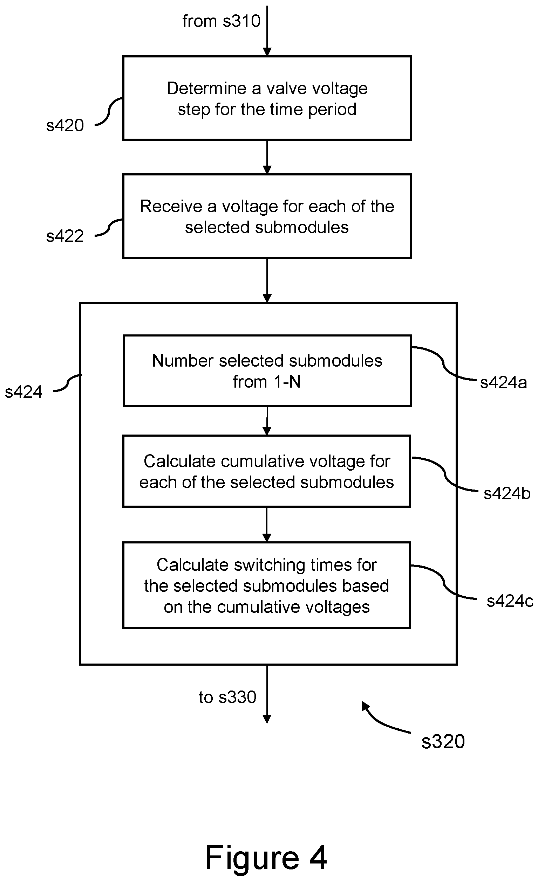

At step s320, the timing controller 240 determines, for each of the selected submodules, a respective switching time. At least one of the respective switching time is different from another of the respective switching times within the time period. The determination of the switching times by the timing controller 240 is described in more detail later below, with reference to Figure 4.

At step s330, optionally, the timing controller 240 determines an adjustment term for the selected submodules. The timing controller 240 can determine the adjustment term by implementing Equation 1 below.

$$A = \sum_{i=1}^{N} \frac{RS(i) \times V_{SM}(i)}{V_S}$$

Equation 1

In Equation 1, $A$ is the adjustment term, $RS(i)$ is the respective switching time for a respective selected submodule i (between 1 and N, where N is the total number of the selected submodules), $V_{SM}(i)$ is a respective voltage of an energy storage device of the selected submodule i, and $V_S$ is a voltage step for the time period. Each of these variables are described in more detail later below in relation to Figure 4.

In other words, the adjustment term A is the sum of the switching times for each of the selected submodules between 1 and N scaled (i.e., multiplied) by the voltage of the respective selected submodule divided by the voltage step for the time period. Thus, the adjustment term A is a quantity which has a unit of time, for example seconds, milliseconds, or microseconds etc.

In some embodiments, the timing controller 240 determines a constant term, which may be applied to the respective switching times instead of or in addition to the adjustment term, in order to shift the respective switching times relative to a start time of the time period. The constant term may be less than or equal to the time period divided by two.

In some embodiments, the timing controller 240 may determine a random value, which may be applied to each of the respective switching times instead of or in addition to the adjustment term and/or the constant term. The random value may be less than 5% of the time period. The random value can be uniform, or can be different for respective selected submodules. The random values tend to provide dithering in the timing, also called Spread-Spectrum Frequency Modulation, which tends to reduce amplitude of high frequency resonance.

In this embodiment, the timing controller 240 applies the adjustment term and the constant term to the switching times of each of the selected submodules, by subtracting the adjustment term from the switching time, and adding the constant term. A purpose of applying the constant term is to reduce control loop latency, by shifting the first respective selected submodule to switch at or close to the start of the time period.

In other words, a purpose of applying the constant term may be to shift the first respective selected submodule to switch at or close to the start of the time period. The typical value of the constant term may be about half of the time period. A smaller constant term than half of the time period may be used to reduce control loop latency.

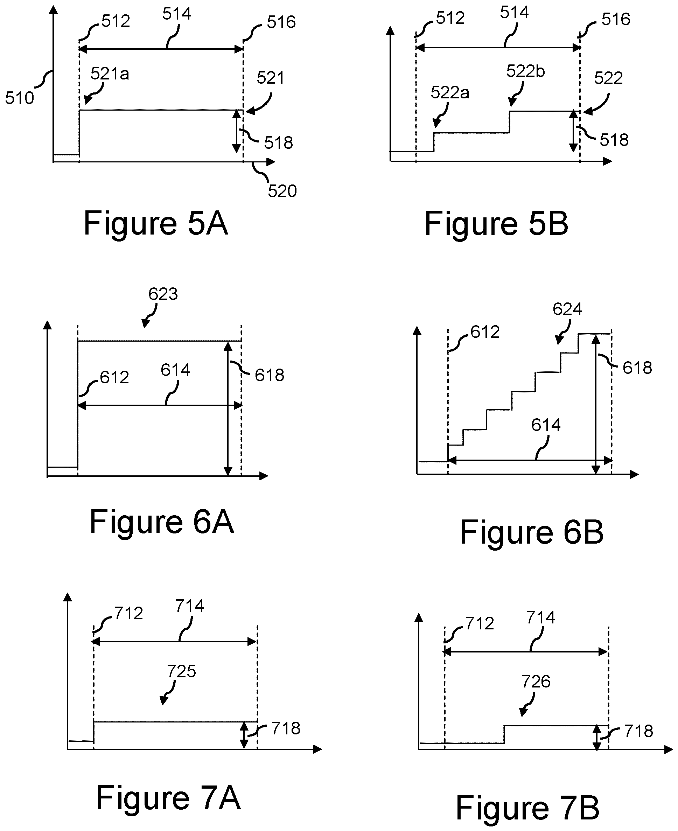

At step s340, the timing controller 240 provides the switching commands 270 to the valve 224. The switching commands 270 specify the selected submodules, and are provided to the valve 224 at the respective switching times for the selected submodules. More specifically, each switching command 270 is associated with a respective one or more of the selected submodules and is sent to that selected submodule at a respective switching time determined for that submodule. This is described in more detail later below with reference to Figures 5A to 9.

In an alternative embodiment, each switching command 270 is associated with a respective one or more of the selected submodules and is sent to that selected submodule, with a respective switching time, determined for that submodule, at the beginning of the time period.

The valve 224 receives the switching commands 270 at the respective switching times, and implements the switching command 270 by switching the selected submodules at the respective switching times. As a result, over the course of the time period, the selected submodules 212 will switch at their respective switching times.

By iteratively implementing the method 300, the timing controller 240 controls the plurality of submodules 212 in the valve 224 over multiple time periods, whereby to produce an output voltage waveform from the valve 224.

Figure 4 is a process flow chart showing an embodiment of steps to determine a respective switching time for each of the selected submodules. The steps disclosed in Figure 4 can be performed during the step s320 of the method 300 of Figure 3.

At step s420, the timing controller 240 determines a voltage step for the time period. The voltage step is a change in a voltage demand from a previous time period to the present respective time period. The change in the voltage demand can be determined by the timing controller 240 based on the command 260, for example by comparing the sum of the selected submodule voltages from the previous time period to the present respective time period, or based on the voltage demand 250, for example by comparing the voltage demand of the previous time period to the present respective time period.

In some embodiments, at step s420, the timing controller 240 optionally compares the change in the voltage demand for the respective time period to an upper limit and a lower limit. The timing controller 240, in response to the change in the voltage demand exceeding the upper limit, sets the change in the voltage demand, as will be used for the determination of the switching times, to the upper limit. Alternatively, the timing controller 240, in response to the change in the voltage demand being below the lower limit, sets the change in the voltage demand, as will be used for the determination of the switching times, to the lower limit. In this manner, the timing controller 240 is able to limit the voltage step such that the method disclosed herein is implemented to a voltage step that is within a preferred defined range. As a result, in such embodiments, the method is not implemented on a voltage step that may be considered outside of the preferred defined range, and so a greater level of control when implementing the method can be achieved. This may be useful, for example, in the event of a fault in the transmission network, wherein it may be required to limit the voltage step to a range of, for example, +/-50kV.

In some embodiments, determining a voltage step for the time period may further comprise the timing controller 240 determining a valve voltage droop caused by a valve current, by implementing Equation 2 below.

$$V_d = -\,\mathrm{T}\,\times\frac{dv}{dt}$$

Equation 2

In Equation 2, $V_d$ is the valve voltage droop, T is the time period, and $\frac{dv}{dt}$ is a rate of change of the valve voltage caused by a valve current. In such embodiments, the valve voltage droop $V_d$ may be added to the change in the voltage demand to determine the voltage step. The timing controller 240 is configured to receive the valve voltage change caused by a valve current from the data 280 received from the valve 224 or power electronics device 290. Thus, the timing controller 240 can receive at least a valve voltage, a valve current, a change in valve voltage from the data 280.

In other embodiments, instead of determining the rate of change of the valve voltage based on the valve current, the rate of change of the valve voltage $\frac{dv}{dt}$ can be determined by implementing Equation 3 below.

$$\frac{dv}{dt} = \sum\nolimits_{i=1}^{M}\frac{dV_c(i)}{dt}$$

Equation 3

In Equation 3, $\frac{dv}{dt}$ is the rate of change of the valve voltage, $\frac{dV_c(i)}{dt}$ is the rate of change of voltage of a respective in-circuit submodule $i$, and M is the total number of in-circuit submodules 212.

An in-circuit submodule is a submodule which is configured such that the energy storage device of the submodule is connected to the valve's circuit and is contributing to the valve output voltage. In other words, an in-circuit submodule is a submodule that is not in a bypass state (a bypass state being a state in which the energy storage device of the submodule is not connected to the valve's circuit and is not contributing to the valve output voltage).

In other embodiments, instead of determining the valve voltage droop based on Equation 2 above, the valve voltage droop $V_d$ can be determined by implementing Equation 4 below.

$$V_d = \sum_{i=1}^{M} V_c'(i) - V_c(i)$$

## Equation 4

In Equation 4, $V_d$ is the valve voltage droop, $V_c'(i)$ is the voltage of a respective in-circuit submodule *i* measured at a previous time period, $V_c(i)$ is the voltage of the respective in-circuit submodule *i* measured at the present time period, and M is the total number of in-circuit submodules 212 in the previous time period.

In other embodiments, the rate of change of the valve voltage $\frac{dv}{dt}$ can be calculated from a valve current and a valve capacitance by implementing Equation 5 below.

$$\frac{dv}{dt} = \frac{I}{C}$$

## Equation 5

In Equation 5, I is the valve current and C is the valve capacitance. Generally, the valve capacitance C changes between time periods. The valve capacitance can be determined for a particular time period by dividing an individual submodule capacitance by the total number of submodules in the valve circuit for that particular time period. This assumes the capacitances of all the submodules are equal. This calculation may be different if the capacitances of submodules are different.

In this manner, at step s420, the timing controller 240 determines a voltage step for the time period.

At step s422, the timing controller 240 receives a voltage for each of the selected submodules 212. The voltage for each of the selected submodules is a voltage of an energy storage device of that selected submodule. For example, the energy storage device of a selected submodule may be one or more capacitors, and the voltage for that selected submodule may be a voltage of its one or more capacitors. The timing controller 240 receives the voltage for each of the selected submodules 212 from the data 280 received from the valve 224 or the power electronics device 290.

At step s424, the timing controller 240 uses the voltage for each of the selected submodules 212 and the voltage step to determine the respective switching times, by implementing steps s424a to s424c.

At step s424a, the timing controller 240 calculates a total number N of the selected submodules 212 based on the command 260. This is possible because, as discussed above, the command 260 specifies the selected submodules 212 to be switched in the respective time period. The timing controller 240 numbers the selected submodules 212 from 1 to N. In other words, each of the selected submodules 212 is assigned a respective number between 1 and N.

At step s424b, the timing controller 240 calculates a cumulative voltage for each of the selected submodules 212 between 1 and N, by implementing Equation 6 below.

$$V_C(n) = \sum_{i=1}^{n} V_{SM}(i)$$

## Equation 6

In Equation 6, *n* is a specific submodule of the selected submodules between 1 and N, $V_C(n)$ is the cumulative voltage for the specific submodule *n,* and $V_{SM}(i)$ is a respective voltage for a respective selected submodule i. Thus, each of the selected submodules 212 will have a cumulative voltage associated with it.

In other words, the timing controller 240 sums the voltage of a respective selected submodule between 1 and N, with the voltages of all of the selected submodules preceding the respective selected submodule in the list or order 1 to N. The first selected submodule between 1 and N will thus have the lowest cumulative voltage, because there are no submodules preceding it to be summed with. The cumulative voltage will increase for each selected submodule after the first selected submodule, and the last selected submodule N will have the greatest cumulative voltage.

At step s424c, the timing controller 240 calculates the switching times for the selected submodules between 1 and N (which in this example are a different switching times for each of the selected submodules), by implementing Equation 7 below.

$$RS(n) = T \times \frac{V_C(n)}{V_S}$$

## Equation 7

In Equation 7, T is the time period, $V_S$ is the voltage step for the time period, and RS($n$) is the switching time of the specific submodule $n$.

In this manner, the timing controller 240 determines a respective switching time (RS($n$)) for each of the selected submodules 212, wherein, within the time period, at least one of the respective switching times is different to another of the respective switching times. In this specific example, all of the respective switching times are different switching times within the time period (T).

Thus, Figure 4 shows an embodiment for determining a respective switching time for each of the selected submodules 212 within the time period, wherein all of the respective switching times are different respective switching times.

In some embodiments, the timing controller 240 may additionally limit the number of selected submodules for which a switching time is to be determined. In such embodiments, the switching controller 240 is configured to compare the total number of selected submodules N to a selected submodule limit. The switching controller 240 may be configured to determine the respective switching times only for the selected submodules within the selected submodule limit. The switching controller 240 may be further configured to determine a static switching time for each of the selected submodules above the selected submodule limit. In such embodiments, the static switching time may be the time period divided by two.

Figure 5A shows an exemplary first plot 521 in which two selected submodules 212 are switched during a time period 514 for a valve controlled using a conventional method. The two submodules have the same voltage level. The first plot 521 shows a change in a valve voltage on a y-axis 510 plotted against time on the x-axis 520. The time period 514 extends from a start time 512 to an end time 516. A voltage step 518 occurs during the time period 514.

Figure 5B shows an exemplary second plot 522 in which two selected submodules 212 are switched during the time period 514 for a valve 224 controlled using the methods disclosed herein. The two submodules have the same voltage level. The second plot 522 shows a change in a valve voltage on a y-axis plotted against time on the x-axis, however these reference numerals, which are common to Figure 5A, have been omitted for clarity. The voltage step 518 occurs during the time period 514.

As can be seen in the first plot 521, in a scenario wherein two selected submodules 212 are switched during the time period 514, as a result of the conventional method, a switching time 521a for each of the two selected submodules 212 tends to occur simultaneously at the start time 512 of the time period 514. As discussed above, the inventors have realised that the simultaneous switching of a plurality of submodules tends to cause resonance. The inventors have further realised that the amount of resonance tends to increase as the number of simultaneously switched submodules increases. Thus, the simultaneous switching of the two selected submodules 212 at the start time 512 tends to cause a first amount of resonance in the valve 224.

In contrast to a valve controlled according to a conventional method (as illustrated in the first plot 521), the second plot 522 illustrates a valve 224 controlled using the methods disclosed herein. As can be seen, the two selected submodules 212 switch at different respective switching times 522a and 522b within the time period 514, i.e. the switching of the two selected submodules 212 is not simultaneous, but the same voltage step 518 is achieved. As a result of not having simultaneous switching, the overall resonance in the valve 212 is reduced, compared to a valve operated according to a conventional method.

A worked example of the scenario discussed in Figure 5B is now provided below, with reference to the method 300 shown in Figures 3 and 4, to facilitate an understanding of the disclosure.

Prior to the start of the method 300, the VBE 230 has determined the command 260. The command 260 specifies that two selected submodules of the plurality of submodules 212 are to be switched in a time period 514.

At step 310 the timing controller 240 determines the time period 514 according to the method steps described above. In other words, the timing controller 240 determines the duration of the time period 514 as extending from a start time 512 to an end time 516. In this example, the time period 514 is 100 microseconds (μs).

At step s320, the timing controller 240 determines, for each of the two selected submodules, a respective switching time 522a, 522b. In this example, the timing controller 240 implements the method steps shown in Figure 4.

Therefore, at step s420, the timing controller 240 determines, based on the command 260, that a voltage step 518 for the time period 514 equals 2kV. In other words, the total amount of voltage change that is to be achieved by the selected submodules switching in the time period 514 is 2kV. Also, at step s420 the timing controller 240 determines that the voltage step is not above the specified upper limit, nor is it below the specified lower limit, and therefore does not apply any limits to the voltage step. The timing controller 240 also does not apply any valve voltage droop calculations.

At step s422, the timing controller 240 receives a voltage for each of the two selected submodules 212. Each of the two selected submodules has a voltage of 1kV, which is information that is supplied to the timing controller 240 from the valve 224 in the data 280.

At step s424a, the timing controller 240 numbers the two selected submodules 212 one (1) and two (2).

At step s424b, the timing controller 240 calculates a cumulative voltage for each of the two selected submodules, by implementing Equation 6 discussed above. Thus, the cumulative voltage for the first and second selected submodules is:

$$V_C(1) = \sum_{i=1}^{1} V_{SM}(i) = 1kV;$$

and

$$V_C(2) = \sum_{i=1}^{2} V_{SM}(i) = 2kV$$

At step s424c, the timing controller 240 calculates the switching times 522a, 522b for the two selected submodules by implementing Equation 7 discussed above. Thus, a respective switching time 522a, 522b for the first and second selected submodules is:

$$RS(1) = 100\mu s \times \frac{1kV}{2kV} = 50\mu s;$$

and

$$RS(2) = 100\mu s \times \frac{2kV}{2kV} = 100\mu s$$

In this manner, the timing controller 240 has determined the respective switching time 522a, 522b for each of the selected submodules 212, wherein at least one of the respective switching times are different switching times within the time period 514. In this particular example, all of the switching times are different switched times within the time period.

However, if the timing controller 240 were to implement the switching times as shown above, there may be a latency or lag as a result of the distribution of the switching times 522a, 522b within the time period 514. As such, these switching times may be referred to as Raw Switching Times. In order to reduce any latency or lag, the timing controller 240 proceeds to step s330.

At step s330, the timing controller 240 determines an adjustment term for each of the selected submodules. The timing controller 240 determines the adjustment term by implementing Equation 1 discussed above. Thus, the adjustment term for the first and second selected submodules is:

$$A = \sum_{i=1}^{2} \frac{RS(i) \times V_{SM}(i)}{2kV} = \frac{50\mu s \times 1kV}{2kV} + \frac{100\mu s \times 1kV}{2kV} = 75\mu s$$

After determining the adjustment term, the timing controller 240 also determines a constant term, C. In this example, the constant term C is the time period divided by two, i.e.:

$$C = \frac{100\mu s}{2} = 50\mu s$$

In this example, the timing controller 240 does not determine a random value.

The timing controller 240 then applies the adjustment term (75μs) and the constant term (50μs) to the switching times 522a, 522b of each of the two selected submodules, by subtracting the adjustment term, and adding the constant term, from the switching times. Thus, the switching times 522a, 522b for the first and second selected submodules become:

$$RS(1) = 50\mu s - 75\mu s + 50\mu s = 25\mu s;$$

and

$$RS(2) = 100\mu s - 75\mu s + 50\mu s = 75\mu s$$

Table 1 below summarises the results of the calculations performed thus far.

Table 1

| Submodule Index | Submodule Voltage (kV) | Accumulated Voltage (kV) | Raw Switching Time ($\mu s$) | Switching Time ($\mu s$) |
|---|---|---|---|---|
| 1 | 1 | 1 | 50 | 25 |
| 2 | 1 | 2 | 100 | 75 |

At step s340, the timing controller 240 provides the switching commands 270, at the respective switching times 522a, 522b for the two selected submodules, to the valve 224.

The valve 224 receives the respective switching command 270 for each of the selected submodules at the respective switching times, and implements the switching of the respective submodule accordingly. Advantageously, a valve with a conventional configuration tends to be able to implement the switching commands 270, and modification of the valve tends not to be necessary.

Thus, as can be seen in the second plot 522, the switching time 522a for the first selected submodule is about $25\mu s$ after the start time 512, and the switching time 522b for the second selected submodule is about $75\mu s$ after the start time 512, considering that the full time period is $100\mu s$. Thus, in this example, the two selected submodules 212 switch at different respective times within the time period 514, and the overall amount of resonance tends to be reduced.

Figures 6A and 6B are similar to Figures 5A and 5B, except that Figures 6A and 6B illustrate a time period 614 wherein seven submodules are switched. Figures 7A and 7B are similar to Figures 5A and 5B, except that Figures 7A and 7B illustrate a time period 714 wherein one submodule is switched. In Figures 6A-7B, like reference numerals from Figure 5A have been omitted for clarity.

In more detail, Figure 6A shows a third plot 623 of a valve operated according to a conventional method wherein seven submodules of 1kV each are switched in a time period 614 to provide a voltage step 618. Figure 6B shows a fourth plot 624 of a valve operated according to the methods disclosed herein, wherein seven submodules of 1kV each are switched in the time period 614 to provide the voltage step 618.

As can be seen in the third plot 623, as a result of the conventional method, the seven submodules are switched simultaneously at a start time 612 of the time period 614. As described above, this tends to cause resonance as a result of the simultaneous switching of the seven submodules. The amount of resonance will be greater compared to the example of two submodules switching discussed in relation to Figure 5A.

The fourth plot 624 shows a valve 224 controlled according to the methods disclosed herein, in particular by following the method steps described above. As a result, and as can be seen, the switching times of the seven selected submodules are at different times within the time period 614. Thus, the seven selected submodules 212 switch at different respective times within the time period 614 to provide the voltage step 618, and the overall amount of resonance tends to be reduced compared to the example discussed in relation to Figure 6A.

Figure 7A shows a fifth plot 725 of a valve controlled using a conventional method, wherein one submodule of 1kV is switched in a time period 714 to provide a voltage step 718. Figure 7B shows a sixth plot 726 of a valve controlled using the methods disclosed herein, wherein one submodule of 1kV is switched in the time period 714 to provide the voltage step 718. As can be seen, in the fifth plot 725 the one selected submodule switches at the start time 712 of the time period 714.

For the sixth plot 726, the voltage step 718 and cumulative voltage values will be nearly equal (neglecting the valve voltage droop and other adjustments), as will the switching time and the adjustment term. As such, the constant term will be the dominant parameter that can be used to re-position or shift the switching time of the one selected submodule relative to the start time 712 of the time period 714. Thus, the constant term is set to half of the time period ($50\mu s$), and as such the switching time for the one selected submodule in the sixth plot 726 is halfway through the time period 714. Note that the constant term may typically be less than $50\mu s$ to reduce latency, but $50\mu s$ has been chosen in order to more clearly illustrate this example.

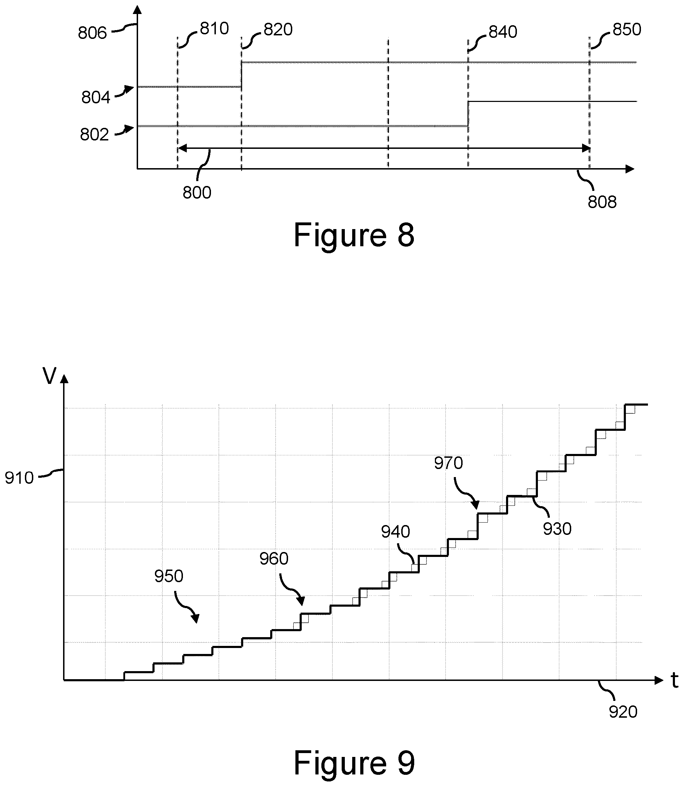

Figure 8 is a plot (not to scale) showing an example of the switching times of two selected submodules, for a valve controlled using the methods disclosed herein. In the example shown in Figure 8, the two selected submodules have different voltages and are switched during a time period 800 which extends from a start time 810 to an end time 850. Figure 8 includes a seventh plot 802 and an eighth plot 804, each of which show a submodule state on a y-axis 806 plotted against time on the x-axis 808.

As illustrated in Figure 8, a first submodule of the two selected submodules has a first switching time 820, and a second submodule of the two selected submodules has a second switching time 840. In this example, the first submodule is 1kV and the second submodule is 2kV. The switching times 820, 840 are calculated using the above-described methods, however because the voltages of the two selected submodules are different, the switching times 820, 840 are not evenly distributed throughout the time period 800, in contrast to the examples discussed above in relation to Figures 5B and 6B.

A worked example of the scenario discussed in Figure 8 is now provided below, with reference to the method 300 shown in Figures 3 and 4, to facilitate an understanding of how to implement the disclosure.

Prior to the start of the method 300, the VBE 230 has determined the command 260. The command 260 specifies that two selected submodules of the plurality of submodules 212 are to be switched in a time period 800.

At step 310 the timing controller 240 determines the time period 800 according to the method steps described above. In other words, the timing controller 240 determines the duration of the time period 800 as extending from a start time 810 to an end time 850. In this example, the time period 800 is 100 $\mu$s.

At step s320, the timing controller 240 determines, for each of the two selected submodules, a respective switching time 820, 840. In this example, timing controller 240 implements the method steps shown in Figure 4.

Therefore, at step s420, the timing controller 240 determines, based on the command 260, that a voltage step for the time period 800 equals 3kV. In other words, the total amount of voltage change that is to be achieved by the selected submodules switching in the time period 800 is 3kV. Also, at step s420 the timing controller 240 determines that the voltage step is not above the specified upper limit, nor is it below the specified lower limit, and therefore does not apply any limits to the voltage step. The timing controller 240 also does not apply any valve voltage droop calculations.

At step s422, the timing controller 240 receives a voltage for each of the two selected submodules 212. One of the selected submodules has a voltage of 1kV, whilst the other selected submodule has a voltage of 2kV. This information is supplied to the timing controller 240 from the valve 224 in the data 280.

At step s424a, the timing controller 240 numbers the two selected submodules 212 one (1) and two (2).

At step s424b, the timing controller 240 calculates a cumulative voltage for each of the two selected submodules, by implementing Equation 6 discussed above. Thus, the cumulative voltage for the first and second selected submodules is:

$$V_C(1) = \sum_{i=1}^{1} V_{SM}(i) = 1kV;$$

and

$$V_C(2) = \sum_{i=1}^{2} V_{SM}(i) = 3kV$$

At step s424c, the timing controller 240 calculates the switching times 820, 840 for the two selected submodules by implementing Equation 7 discussed above. Thus, the switching times 820, 840 for the first and second selected submodules are:

$$RS(1) = 100\mu s \times \frac{1kV}{3kV} = 33.3\mu s;$$

and

$$RS(2) = 100\mu s \times \frac{3kV}{3kV} = 100\mu s$$

In this manner, the timing controller 240 has determined a respective switching time 820, 840 for each of the selected submodules 212, wherein the respective switching times are different switching times within the time period 800. In this particular example, all of the switching times are different switching times within the time period.

However, if the timing controller 240 were to implement the switching times as shown above, there may be a latency or lag as a result of the distribution of the switching times 820, 840 within the time period 800. Therefore, the timing controller 240 proceeds to step s330.

At step s330, the timing controller 240 determines an adjustment term for each of the selected submodules. The timing controller 240 determines the adjustment term by implementing Equation 1 discussed above. Thus, the adjustment term for the first and second selected submodules is:

$$A = \sum_{i=1}^{2} \frac{RS(i) \times V_{SM}(i)}{3kV} = \frac{33.3\mu s \times 1kV}{3kV} + \frac{100\mu s \times 2kV}{3kV} = 77.7\mu s$$

After determining the adjustment term, the timing controller 240 also determines a constant term, C. In this example, the constant term C is the time period divided by two, i.e.:

$$C = \frac{100\mu s}{2} = 50\mu s$$

In this example, the timing controller 240 does not determine a random value.

The timing controller 240 then applies the adjustment term (77.7 $\mu$s) and the constant term (50 $\mu$s) to the switching times 820, 840 of each of the two selected submodules, by subtracting the adjustment term, and adding the constant term, from the switching times. Thus, the switching times 820, 840 for the first and second selected submodules become:

$$RS(1) = 33.3\mu s - 77.7\mu s + 50\mu s = 5.6\mu s;$$

and

$$RS(2) = 100\mu s - 77.7\mu s + 50\mu s = 72.3\mu s$$

Table 2 below summarises the results of the calculations performed thus far.

Table 2

| Submodule Index | Submodule Voltage (kV) | Accumulated Voltage (kV) | Raw Switching Time (μs) | Switching Time (μs) |
|---|---|---|---|---|
| 1 | 1 | 1 | 33.3 | 5.6 |
| 2 | 2 | 3 | 100 | 72.3 |

At step s340, the timing controller 240 provides the respective switching commands 270 to the valve 224 at the respective switching times 820, 840 for the two selected submodules.

The valve 224 receives the switching command 270 for each of the selected submodules at the respective switching times, and implements the switching of the respective submodule accordingly.

Thus, as can be seen in Figure 8, the switching time 820 for the first selected submodule is about 5.6ps after the start time 810, and the switching time 840 for the second selected submodule is about 72.3ps after the start time 810, considering that the full time period 800 is 100 $\mu$s. Thus, the selected submodules 212 switch at different respective times within the time period 800, and the overall amount of resonance tends to be reduced.

Furthermore, the method tends to effectively calculate the optimal switching time for each of the selected submodules based on the submodule capacitor voltage, by providing a greater weighting to the switching time of submodules with a higher voltage. This tends to produce a valve output voltage curve for the respective time period that is closer to an ideal valve output voltage curve.

Figure 9 is a graph showing the output voltage of a valve 224 on the y-axis 910 plotted against time on the x-axis 920. Figure 9 shows a ninth plot 930 of a valve controlled using a conventional method (bold plot), and a tenth plot 940 of a valve 224 controlled using the methods disclosed herein (non-bold plot). Plot 930 is shifted by a fixed adjustment term for easier visual comparation.

As can be seen, in the ninth plot 930 and the tenth plot 940, the output voltage of the valve increases in regular periods. The regular period in which the output voltage changes is the time period. In a first portion 950 of both the ninth and tenth plots 930, 940 the output voltage of the valve 224 increases in such a way that there is no visible difference between the ninth plot 930 and the tenth plot 940. This is because, for each time period during the first portion 950, only one submodule is switching.

At a first time period 960 after the first portion 950, a visible difference between the ninth plot 930 and the tenth plot 940 is seen, in that the ninth plot 930 shows a larger, single voltage rise, whereas the tenth plot 940 shows two smaller voltage rises, at different times at the time period 960.

At the first time period 960, the ninth plot 930 is thus synonymous to the example discussed above in relation to Figure 5A (i.e., two selected submodules of equal voltage switching simultaneously in the time period), and the tenth plot is synonymous to the example discussed above in relation to Figure 5B (i.e., two selected submodules of equal voltage switching at different switching time in the time period). As a result, at the first time period 960, the valve 224 controlled according to the methods disclosed herein (and illustrated in the tenth plot 940) tends to produce less resonance when compared to the valve controlled according to conventional methods (and illustrated in the ninth plot 930).

After the first time period 960, there are a number of further time periods which also have the same switching characteristic as the first time period 960. Thus, the valve 224 controlled according to the methods disclosed herein, and illustrated in the tenth plot 940, tends to produce less resonance during each of the further time periods when compared to the valve controlled according to conventional methods, and illustrated in the ninth plot 930.

At a second time period 970 after the first time period 960, a greater visible difference between the ninth plot 930 and the tenth plot 940 is seen. In the second time period 970, the ninth plot 930 shows a larger, single voltage rise, whereas the tenth plot 940 shows three smaller voltage rises at different times within the second time period 970.

At second time period 970, the ninth plot 930 is synonymous to the example discussed above in relation to Figure 6A, however with three selected submodules of equal voltage switching in a time period. The tenth plot is synonymous to the example discussed above in relation to Figure 6B, however with three selected submodules of equal voltage switching in a time period. As a result, at the second time period 970, the valve 224 controlled according to the methods disclosed herein (and illustrated in the tenth plot 940) tends to produce less resonance when compared to the valve controlled according to conventional methods (and illustrated in the ninth plot 930).

After the second time period 970, there are a number of further time periods which also have the same switching characteristic as the second time period 970.

Over the course of the full waveform, the resonance produced by the valve 224 controlled according to the methods disclosed herein tends to be considerably less when compared to the valve controlled according to conventional methods.

Although the above-described embodiments disclose a controller 160 comprising a VBE 230 and a timing controller 240, the disclosure should not be limited there to.

In other embodiments, the VBE 230 and the timing controller 240 may be combined as a single function into the controller 160. In other words, in such embodiments, the controller 160 may be configured to perform the functionally of the VBE 230 and the timing controller 240 by means of a single controller unit. In such embodiments, the controller 160 may described as an enhanced VBE controller.

In other embodiments, the function of the timing controller 240 may be incorporated into a higher-level controller.

The total valve voltage output droop at a high valve current can be up to three times (x3) the voltage of a submodule, which may make the methods disclosed herein less effective. As such, in some embodiments, step s420, to determine a valve voltage step, may be based on the actual valve voltage step instead of the step of the voltage demand 250.

Although in the above-described embodiments the STATCOM 170 has a delta-connected topology or a star-connected topology, the disclosure should not be limited there to.

In other embodiments, the STATCOM 170 may be a power converter operating as a STATCOM, for example the first or second power converters 110, 120. In such embodiments, the STATCOM effectively comprises 6-valves.

In other embodiments, the STATCOM 170 may be a power converter operating as a STATCOM and/or a power converter, for example the first or second power converters 110, 120. In such embodiments, the STATCOM effectively comprises 6-valves.

The first and/or second power converters 110, 120 may be Voltage Source Converters. The first and/or second power converters 110, 120 may be Modular Multilevel Converters comprising a plurality of valves. Each valve may comprise a plurality of submodules.

In other embodiments, any power conversion means comprising a valve may be controlled by the controller 160 according to the methods disclosed herein.

Although in the above-described embodiments the timing controller 240 provides each switching command 270 to a respective selected submodule at a respective switching time determined for that submodule, the disclosure should not be limited there to.

In other embodiments, the switching command includes the respective switching times (or information indicative of the respective switching times), such that the switching command does not need to be provided at the switching times. In such embodiments, the switching command can be provided at the start of the time period, or during a previous time period, and the valve or a valve controller is configured to use the information of the switching times (contained in the switching command) to switch the submodules at the different switching times.

Although various specific equations have been disclosed above in relation to the method disclosed herein, the disclosure should not be limited to any of these specific equations. In particular, alternative equations that can achieve the same outcome should be considered to be within the scope of this disclosure. Therefore, in some embodiments, the method may use simplified calculations or alternative calculations that achieve similar results.

In particular, when calculating the response times, the method may comprise the steps of: measuring the duration of control cycle (Tc), calculating change of valve voltage demand, saturating the valve voltage demand change to +-50kV (Vd_step), calculating the achieved voltage of each selected submodule (Vsum(n)), calculating the response time by using the equation: (saturate the value between 0 - 2*Tsw): 2*Tsw - (Tc - Tc * Vsum(n) / V_dstep)), wherein Tsw is a nominal switching time, and typically, Tsw = Tc/2, but it can be a smaller value to reduce control delay. Note, overflowed switching has a delay of 2*Tsw.

Alternatively, when calculating the response times, the method may comprise the steps of: measuring the duration of control cycle (Tc), calculating change of valve voltage demand, saturate the vDemand change, +-50kV (Vd_step), accumulating the voltage of the selected submodules (Vsum(n)), and calculating the response time by using the equation: RawSwTime (n) = (Tc / 2) * Round(Vsum(n) / Vd_step), followed by using the equation: SwTime(n) = RawSwTime(n) - (Σ (RawSwTime * vCap))/ Vd_step + Tsw. Typicaly, set Tsw = Tc/4 (Saturate the Delay between 0 to 2*Tsw). Note, overflowed switching has a delay of Tsw.

## Claims

1. A method for controlling a plurality of submodules in a valve of a power electronics device, the method comprising:

   determining, by a controller, a time period in which selected submodules of the plurality of submodules are to be switched in order to control an output voltage of the valve;
   determining, by the controller, for each of the selected submodules, a respective switching time, within the time period, based on a voltage demand for the time period and a voltage of each of the selected submodules, wherein at least one of the respective switching times is different to another of the respective switching times;
   generating, by the controller, a respective switching command for each of the selected submodules; and
   providing, by the controller, the respective switching commands to the valve, whereby to control the selected submodules to switch at the respective switching times within the time period.

2. The method of claim 1, wherein

   each respective switching command includes the respective switching time; and
   the respective switching commands are provided to the valve substantially at the start of, or before, the time period.

3. The method of claim 1, wherein each respective switching command is provided to the valve at the respective switching time.

4. The method of any preceding claim, further comprising:

   specifying, by the controller, the selected submodules of the plurality of submodules to be switched during the time period; or
   receiving, by the controller, a command which specifies the selected submodules of the plurality of submodules to be switched during the time period.

5. The method of any preceding claim, further comprising:

   determining, by the controller, a voltage step for the time period by calculating a change in a voltage demand for the valve during the time period;
   receiving, by the controller, the voltage of each of the selected submodules from the valve; and
   using, by the controller, the voltage for each of the selected submodules and the voltage step to determine the respective switching times.

6. The method of claim 5, wherein using the voltage for each of the selected submodules and the voltage step to determine the respective switching times comprises:

   numbering, by the controller, the selected submodules from 1 to N, wherein N is a total number of the selected submodules;
   calculating, by the controller, a cumulative voltage for each of the selected submodules between 1 and N, by implementing the equation:

$$V_C(n) = \sum_{i=1}^{n} V_{SM}(i)$$

wherein n is a specific submodule of the selected submodules between 1 and N, $V_C(n)$ is the cumulative voltage for the specific submodule *n*, and $V_{SM}(i)$ is a respective voltage for a respective selected submodule i; and calculating, by the controller, the switching times for the selected submodules between 1 and N, by implementing the equation:

$$RS(n) = T \times \frac{V_c(n)}{V_S}$$

wherein T is the time period, $V_S$ is the voltage step for the time period, and RS(*n*) is the switching time of the specific submodule n.

7. The method of claim 6, further comprising:

comparing, by the controller, the total number of selected submodules N to a selected submodule limit; and if the total number of selected submodules is less than or equal to the selected submodule limit, then determining, by the controller, the respective switching times for the selected submodules; or if the total number of selected submodules is greater than the selected submodule limit, then determining, by the controller, the respective switching times for a number of selected submodules equal to the selected submodule limit, and determining a static switching time for each remaining selected submodule.

8. The method of claim 6 or 7, further comprising:

determining, by the controller, an adjustment term by implementing the equation:

$$A = \sum_{i=1}^{N} \frac{RS(i) \times V_{SM}(i)}{V_S}$$

wherein A is the adjustment term, and RS(*i*) is the respective switching time for a respective selected submodule i; and determining, by the controller, respective adjusted switching times for the respective submodules, by subtracting the adjustment term from the respective switching times for the selected submodules.

9. The method of any one of claims 5 to 8, wherein determining the voltage step for the time period further comprises:

determining, by the controller, a valve voltage droop caused by a valve current; and adding, by the controller, the valve voltage droop to the change in the voltage demand to determine the voltage step.

10. The method of any one of claims 5 to 9, wherein determining the voltage step for the time period further comprises:

comparing, by the controller, the change in the voltage demand to an upper limit and a lower limit; setting, by the controller, in response to the change in the voltage demand exceeding the upper limit, the change in the voltage demand to the upper limit; or setting, by the controller, in response to the change in the voltage demand being lower than the lower limit, the change in the voltage demand to the lower limit.

11. The method of any preceding claim, further comprising adding, by the controller, a constant term to each of the respective switching times in order to shift the respective switching times relative to the time period, wherein the constant term is substantially less than or equal to the time period divided by two.

12. The method of any preceding claim, further comprising adding, by the controller, a random value to each of the respective switching times, wherein the random value is substantially less than the time period.

13. A controller for controlling a plurality of submodules in a valve (224) of a power electronics device, the controller configured to:

   determine a time period in which selected submodules of the plurality of submodules are to be switched in order to control an output voltage of the valve;
   determine for each of the selected submodules, a respective switching time, within the time period, based on a voltage step for the time period and a voltage of each of the selected submodules, wherein at least one of the respective switching times is different to another of the respective switching times;
   generate respective switching commands for each of the selected submodules; and
   provide the respective switching commands to the valve, whereby to control the selected submodules to switch at the respective switching times within the time period.

14. The controller of claim 13, wherein the controller is further configured to:

   determine a voltage step for the time period by calculating a change in a voltage demand for the valve during the time period;
   receive the voltage of each of the selected and/or in-circuit submodules from the power electronics device; and
   use the voltage for each of the selected and/or in-circuit submodules and the voltage step to determine the respective switching times.

15. A power electronics device comprising:

   one or more valves, wherein each valve comprises a plurality of submodules, and wherein each valve is configured to output a voltage for an AC network; and
   the controller of claim 13 or 14 configured to control each valve.

Figure 1A

Figure 1B

Figure 2A

Figure 2B

Figure 2C

START

Determine time period

s310

Determine a switching
time for each of the
selected submodules

s320

Determine and apply
the adjustment term

s330

Provide switching command to
valve to switch submodules

s340

END

300

Figure 3

from s310

```
┌─────────────────────────────┐
│   Determine a valve voltage  │
│    step for the time period  │
└─────────────────────────────┘
```
s420

```
┌─────────────────────────────┐
│   Receive a voltage for each of the │
│      selected submodules     │
└─────────────────────────────┘
```
s422

s424

```
┌─────────────────────────────┐
│  Number selected submodules  │
│           from 1-N           │
└─────────────────────────────┘
```
s424a

```
┌─────────────────────────────┐
│  Calculate cumulative voltage for │
│   each of the selected submodules │
└─────────────────────────────┘
```
s424b

```
┌─────────────────────────────┐
│   Calculate switching times for │
│  the selected submodules based │
│    on the cumulative voltages │
└─────────────────────────────┘
```
s424c

to s330

s320

# Figure 4

Figure 5A

Figure 5B

Figure 6A

Figure 6B

Figure 7A

Figure 7B

Figure 8

Figure 9

| Europäisches Patentamt<br>European Patent Office<br>Office européen des brevets | **EUROPEAN SEARCH REPORT** | **Application Number**<br>EP 24 20 5016 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BAZYAR SATTAR ET AL: "Quasi two-Level Modulation for the MMC-Based Isolated DC/DC Converter",<br>2023 IEEE ENERGY CONVERSION CONGRESS AND EXPOSITION (ECCE), IEEE,<br>29 October 2023 (2023-10-29), pages 2424-2430, XP034508520,<br>DOI: 10.1109/ECCE53617.2023.10362146<br>[retrieved on 2023-12-29]<br>* Section III;<br>figures 1-3 * | 1-15 | INV.<br>H02M1/00<br>H02M1/44<br>H02M7/483 |
| X | SHUHUAI SHI ET AL: "High power DC/AC/DC converter based on different modulation strategies",<br>2016 IEEE 8TH INTERNATIONAL POWER ELECTRONICS AND MOTION CONTROL CONFERENCE (IPEMC-ECCE ASIA), IEEE,<br>22 May 2016 (2016-05-22), pages 315-320, XP032924292,<br>DOI: 10.1109/IPEMC.2016.7512305<br>[retrieved on 2016-07-13]<br>* Section II.B;<br>figures 1, 3-5 * | 1-15 | |
| X | SOOMRO JAHANGEER BADAR ET AL: "Modified Nearest Level Modulation for Full-Bridge Based HVDC MMC in Real-Time Hardware-in-Loop Setup",<br>IEEE ACCESS, IEEE, USA,<br>vol. 9, 18 August 2021 (2021-08-18), pages 114998-115005, XP011873724,<br>DOI: 10.1109/ACCESS.2021.3105690<br>[retrieved on 2021-08-20]<br>* Chapters III-IV;<br>figures 1-3 * | 1-15 | TECHNICAL FIELDS SEARCHED (IPC)<br><br>H02M |

-/--

The present search report has been drawn up for all claims

| Place of search | Date of completion of the search | Examiner |
|---|---|---|
| The Hague | 5 March 2025 | Madouroglou, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

| | Europäisches Patentamt European Patent Office Office européen des brevets | **EUROPEAN SEARCH REPORT** | Application Number EP 24 20 5016 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | SHAN YUE ET AL: "Space Spread-Spectrum Strategy for MMC to Reduce the Conducted EMI", IEEE TRANSACTIONS ON INDUSTRIAL ELECTRONICS, IEEE SERVICE CENTER, PISCATAWAY, NJ, USA, vol. 69, no. 11, 10 November 2021 (2021-11-10), pages 10807-10818, XP011910510, ISSN: 0278-0046, DOI: 10.1109/TIE.2021.3125656 [retrieved on 2021-11-11] * Section III.B; table III * ----- | 12 | |

TECHNICAL FIELDS SEARCHED (IPC)

The present search report has been drawn up for all claims

| Place of search | Date of completion of the search | Examiner |
|---|---|---|
| The Hague | 5 March 2025 | Madouroglou, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...............................................................................................

& : member of the same patent family, corresponding document

EPO FORM 1503 03.82 (P04C01)